**Europäisches Patentamt**

**European Patent Office**

**Office européen des brevets**

(19)

(11) Veröffentlichungsnummer: **0 065 675**
**B1**

(12) # EUROPÄISCHE PATENTSCHRIFT

(45) Veröffentlichungstag der Patentschrift:
**16.10.85**

(21) Anmeldenummer: **82103874.2**

(22) Anmeldetag: **05.05.82**

(51) Int. Cl.⁴: **G 01 R  27/02,** G 01 R  27/26,
G 01 R  27/22

(54) **Verfahren und Schaltungsanordnung zur Messung der Impedanz eines Sensors.**

(30) Priorität: **18.05.81  CH 3218/81**

(43) Veröffentlichungstag der Anmeldung:
**01.12.82 Patentblatt 82/48**

(45) Bekanntmachung des Hinweises auf die Patenterteilung:
**16.10.85 Patentblatt 85/42**

(84) Benannte Vertragsstaaten:
**DE FR GB IT**

(56) Entgegenhaltungen:
**FR - A - 2 049 584**
**FR - A - 2 386 934**
**US - A - 4 220 920**

**ELECTRONICS & POWER, Band 23, Nr. 5, Mai 1977,
Seiten 385-388, Hitchin Herts, G.B. M.S. RAVEN et al.:
"Advances in the measurement of capacitance"
RADIO FERNSEHEN ELEKTRONIK, Jahrgang 27, Nr. 12,
Dezember 1978, Seiten 765-766 R.ALTMANN:
"Phasenempfindlicher Gleichrichter als
Präzisionsgleichrichter"
ELECTRONIC ENGINEERING, Band 45, Nr. 541, März
1973, Seiten 18-19 W.J. MACKEN: "Synchronous and
nonsynchronous rectification with op.amp."
ELECTRONICS LETTERS, Band 11, Nr. 24, November
1975, Seiten 573-574, Herts, G.B. H. GAD:
"Phasenselektiver Gleichrichter mit grosser
Bandbreite"**

(73) Patentinhaber: **Novasina AG, Thurgauerstrasse 50,
CH-8050 Zürich (CH)**

(72) Erfinder: **Horn, Petr, Birchstrasse 159,
CH-8156 Oberhasli (CH)**

(74) Vertreter: **Blum, Rudolf Emil Ernst et al, c/o E. Blum &
Co Patentanwälte Vorderberg 11, CH-8044 Zürich (CH)**

# Beschreibung

Die Erfindung betrifft ein Verfahren zur Messung der Impedanz eines Sensors mittels einer sinusförmigen Wechselspannung mit einer vorbestimmten Frequenz, wobei die sinusförmige Wechselspannung gemeinsam mit einer zu der sinusförmigen Wechselspannung synchron laufenden, rechteckförmigen Wechselspannung erzeugt und an eine die zu messende Impedanz enthaltende Messschaltung abgegeben wird.

Sie betrifft ferner eine Schaltungsanordnung zur Durchführung dieses Verfahrens mit einer Oszillatorschaltung zur Erzeugung einer sinusförmigen Wechselspannung und einer zu der sinusförmigen Wechselspannung synchron laufenden, rechteckförmigen Wechselspannung, mit einer an die Oszillatorschaltung angeschlossenen und die zu messende Impedanz enthaltenden Messschaltung, mit einer Gleichrichter- und Tiefpassschaltung und mit einer zwischen der Messschaltung und der Gleichrichter- und Tiefpassschaltung angeschlossenen Filterschaltung.

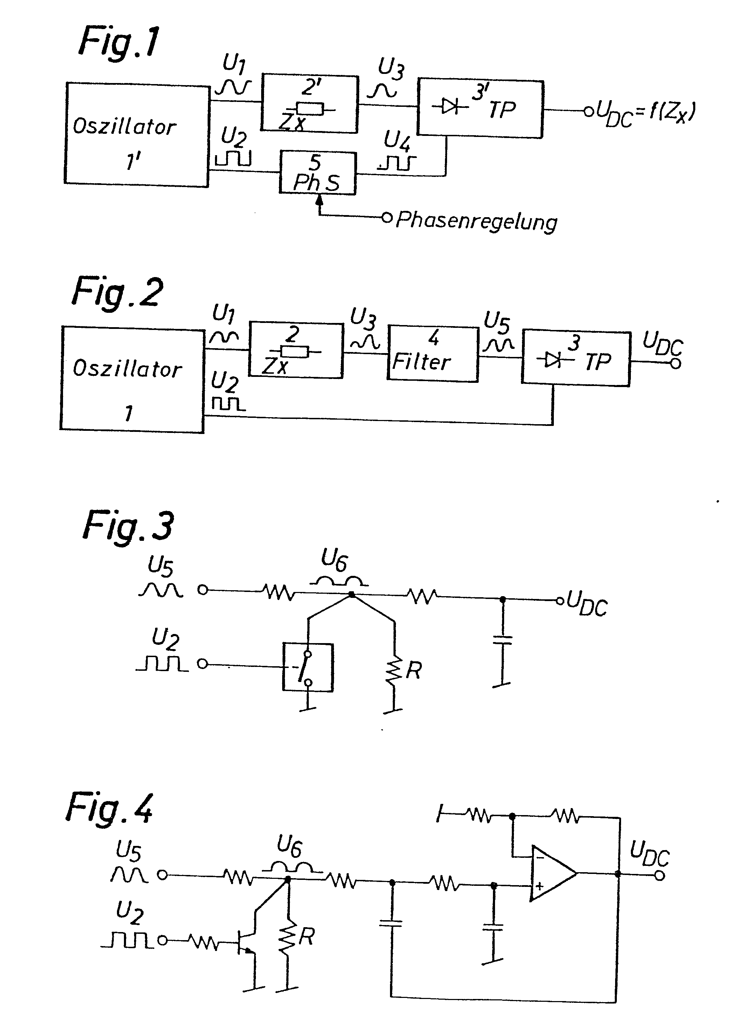

Zur Messung von Impedanzen mittels einer sinusförmigen Wechselspannung gemäss Oberbegriff von Anspruch 1 bietet sich die in Fig. 1 angedeutete Möglichkeit nach H. Helke «Messbrücken und Kompensatoren für Wechselstrom», R. Oldenburg Verlag, 1971, S. 243 an, die auf dem Prinzip eines Lock-in-Verstärkers beruht, der für variable Frequenz verwendbar ist. Die sinusförmige Wechselspannung wird an eine die zu messende Impedanz $Z_x$ enthaltende Messschaltung abgegeben, deren Ausgangssignal einer Gleichrichterstufe zugeführt wird, welche von einer rechteckigen Wechselspannung gesteuert wird. Zur Gleichstellung der Phasen der beiden Wechselsignale, was Voraussetzung für das einwandfreie Funktionieren ist, wird die Phase der rechteckigen Wechselspannung geregelt.

Eine bekannte Schaltung gemäss Electronics & Power, Band 23, Nr. 5, Mai 1977, S. 387, verwendet zwar eine Filterschaltung im Messkreis, welche jedoch nicht die Funktion hat, die Messspannung in eine vorbestimmte Phasenbeziehung zur rechteckigen Wechselspannung zu bringen.

Aus der FR-A-2 049 584 ist ferner eine Schaltung bekannt, welche als Gleichrichterstufe einen von einem Rechtecksignal gesteuerten Schalter aufweist, wobei allerdings keine Filterschaltung im Messkreis vorgesehen ist. Die genannten Schaltungen sind einerseits relativ aufwendig und für die angestrebte Messgenauigkeit kaum geeignet.

Die Aufgabe der Erfindung ist es, ein Messverfahren sowie eine Messschaltung des eingangs erwähnten und vorstehend erläuterten Typs derart zu verbessern, dass eine Linearität bis zu sehr kleinen Messspannungen (mV-Bereich) erhalten bleibt, wobei durch Einschränkung auf eine vorbestimmte Frequenz eine kostengünstige Lösung erreicht werden soll.

Die genannte Aufgabe wird in optimaler Weise überraschend dadurch gelöst, dass die der Impedanz proportionale, aus der Messschaltung abgegebene Wechselspannung in einer selektiven Schaltung mit einem vorbestimmten Amplituden- und Phasengang in eine vorbestimmte Phasenbeziehung zu der rechteckförmigen Wechselspannung gebracht und dann mit Hilfe der rechteckförmigen Wechselspannung gleichgerichtet und in eine der Impedanz proportionale Gleichspannung umgewandelt wird, wobei die Gleichrichtung der der Impedanz proportionalen Wechselspannung und die Umwandlung in die der Impedanz proportionale Gleichspannung in einer Gleichrichter- und Tiefpassschaltung mit Hilfe eines Schalters, der durch die rechteckförmige Wechselspannung gesteuert wird, durch Kurzschliessen eines geerdeten Widerstandes der Tiefpassschaltung durchgeführt wird.

Die erfindungsgemässe Schaltungsanordnung zur Durchführung dieses Verfahrens ist nach Anspruch 2 aufgebaut.

Nachfolgend wird eine Schaltung gemäss dem Stand der Technik sowie die Erfindung anhand der beiliegenden Zeichnungen näher erläutert.

Es zeigen:

Fig. 1 ein Blockdiagramm eines bekannten Lock-in-Verstärkers;

Fig. 2 ein Blockdiagramm einer Schaltungsanordnung ohne Phasenregelung,

Fig. 3 und Fig. 4 Beispiele der Gleichrichter- und Tiefpassschaltung gemäss der Erfindung;

Fig. 5 und Fig. 6 Beispiele der Messschaltung und

Fig. 7 ein Blockdiagramm der erfindungsgemässen Schaltungsanordnung zur Messung einer elektrolytischen Impedanz.

In Fig. 1 ist ein Blockdiagramm des bekannten Lock-in-Verstärkers in der Anwendung zur Messung einer Impedanz Zx gekennzeichnet. In einem Oszillator 1' wird eine sinusförmige U1 und eine rechteckförmige U2 Wechselspannung mit der gleichen Frequenz erzeugt. Die sinusförmige Spannung wird an eine die zu messende Impedanz Zx aufweisende Messschaltung abgegeben. Die Messschaltung 2' kann aus einer Brückenschaltung und einer Verstärkerschaltung bestehen und gibt eine der Impedanz Zx proportionale sinusförmige Wechselspannung U3 ab. Diese Wechselspannung U3 wird einer Gleichrichter- und Tiefpassschaltung 3' zugeführt. Oft wird die Gleichrichterstufe in dieser Schaltung 3' auch als Mischstufe oder Demodulatorstufe bezeichnet. Der Gleichrichterstufe wird auch eine rechteckförmige Wechselspannung U4 zugeführt, nachdem sie in einen Phasenschieber 5 aus der rechteckförmigen Wechselspannung U2 gewonnen wurde. Die Bedingung für ein fehlerfreies Funktionieren des Lock-in-Verstärkers ist, dass die Spannungen U3 und U4 phasengleich sind. Dies kann man durch eine Regelung der Phasenverschiebung im Phasenschieber 5 erreichen. Wenn der Lock-in-Verstärker nur mit einer festen Frequenz betrieben wird, kann die Phasenregelung durch einen einmaligen Abgleich ersetzt werden.

In Fig. 2 ist ein Blockdiagramm der Messanordnung ohne Phasenregelung gezeichnet, welche der Erfindung zugrunde liegt. Die Funktion des Phasenschiebers 5 aus Fig. 1 wird durch eine Filterschaltung 4 übernommen. Anstatt die Phase der Rechteckspannung U2 zu regeln, wird die Phase der, der zu messenden Impedanz Zx proportionalen Wechselspannung U3 im Gegensatz zu allen anderen Störfrequenzen in der Filterschaltung 4 so phasenverschoben, dass die Ausgangsspannung U5 der Filterschaltung 4 phasengleich mit der Rechteckspannung U2 ist. Damit sind am Eingang der Gleichrichter- und Tiefpassschaltung 3 wieder zwei gleichphasige, eine sinus- und eine rechteckförmige Wechselspannung wie bei einem Lock-in-Verstärker in Fig. 1 vorhanden. Die Anordnung gemäss Fig. 2 weist verschiedene Vorteile auf, wie aus den folgenden Ausführungsbeispielen ersichtlich wird.

Die Filterschaltung 4 in Fig. 2 kann als Allpassschaltung 1. Ordnung, im folgenden als Allpass genannt, ausgebildet sein. Der Allpass 1. Ordnung lässt Wechselsignale mit allen Frequenzen ohne Dämpfung durch.

Die Wechselsignale, deren Frequenz in der Nähe der Polfrequenz des Allpasses liegen, werden anders phasenverschoben als alle anderen Wechselsignale. Die Phasenverschiebung bei der Polfrequenz beträgt $+90°$ oder $-90°$.

Als Oszillator kann ein integrierter Schaltkreis 8038 (Hersteller Intersil oder Exar) verwendet werden, dessen Rechteckspannung U2 und Sinusspannung U1 um 90° phasenverschoben sind. Wenn zwischen den Sinusspannungen U1 und U3 keine Phasenverschiebung stattfindet und wenn die Schwingfrequenz des Oszillators gleich der Polfrequenz des Allpasses ist, wird die Phasenverschiebung zwischen den Spannungen U2 und U5 je nach dem verwendeten Allpass 0° oder $\pm$ 180° betragen. Die dritte Oberwelle, welche bei dem Lock-in-Verstärker in Fig. 1 durchgeschaltet wird, wird aber durch den Allpass um 53,13° gegenüber der Grundwelle verschoben. Dadurch wird der Beitrag der Oberwelle an der Gleichspannung $U_{DC}$ durch die Verwendung des Allpasses 1. Ordnung gegenüber dem Lock-in-Verstärker reduziert.

Durch eine geeignete Wahl des Filters 4 in Fig. 2 lässt sich diese Verbesserung noch steigern, was im folgenden gezeigt wird. Dies wird durch Ausbildung der Filterschaltung 4 als Bandpassschaltung 2. Ordnung, im folgenden als Bandpass genannt, erreicht. Im Gegensatz zum Allpass kann der Phasengang in der Umgebung der Polfrequenz wesentlich steiler durchlaufen, und der Amplitudengang bewirkt, dass ausser der gewünschten Phasenverschiebung auch eine Amplitudendämpfung für die unerwünschten Stör- und Oberwellen zusätzlich erfolgt. Bei dieser Ausführung müssen, unter der Voraussetzung, dass keine Phasenverschiebung in der Messschaltung 2 erfolgt, die Rechteckspannung U2 und die Sinusspannung U1 zeitgleiche Nulldurchgänge aufweisen.

Die Schwingfrequenz des Oszillators ist dann gleich der Polfrequenz des Bandpasses, und die Sinusspannung U5 ist gegenüber der Rechteckspannung U2 um 0° oder $\pm$ 180° phasenverschoben. Die dritte Oberwelle kann nun, je nach der Bandbreite oder Güte des Bandpasses, um mehr als 53° gegenüber der Grundwelle, die gleich der Polfrequenz des Bandpasses ist, phasenverschoben sein. Schon die zusätzliche Phasenverschiebung (z. B. 80°) gegenüber der Grundwelle allein bewirkt die Verminderung des Einflusses der Oberwelle auf die Gleichspannung $U_{DC}$. Die Dämpfung der Amplitude der Oberwelle durch den Bandpass bringt eine weitere Verbesserung gegenüber dem Ausführungsbeispiel 1 und dem Lock-in-Verstärker mit sich.

Die Gleichrichter- und Tiefpassschaltung ist nun erfindungsgemäss so ausgebildet, dass mittels eines Schalters ein geerdeter Widerstand der Tiefpassschaltung kurzgeschlossen werden kann.

In Fig. 3 ist ein Ausführungsbeispiel einer solchen Gleichrichter- und Tiefpassschaltung 3 dargestellt. Im Gegensatz zu einem Lock-in-Verstärker, bei dem die Sinusspannung U3 mittels der Rechteckspannung an einem Kondensator geschaltet und die resultierende gleichgerichtete Spannung erst danach mittels eines Tiefpasses in die Gleichspannung $U_{DC}$ umgewandelt wird, wird hier die Gleichspannung $U_{DC}$ mit Hilfe eines Schalters, der durch die Rechteckspannung U2 gesteuert wird, durch Kurzschliessen eines geerdeten Widerstandes R einer Tiefpassschaltung 1. Ordnung abgeleitet.

An dem Widerstand R erscheint dann die Halbwelle U6 der Sinusspannung U5. Mit dieser Schaltung in Fig. 3 wird die Ladung des Kondensators nicht abrupt geschaltet, und es entstehen keine störende Spannungsspitzen. Die Linearität der Schaltung wurde dadurch besonders für sehr kleine Spannungen (mV-Bereich) als besonders gut befunden.

In Fig. 4 ist ein Ausführungsbeispiel der Gleichrichter- und Tiefpassschaltung 3 als eine Verbesserung der Schaltung in Fig. 3 dargestellt. Der Schalter ist mit einem Transistor realisiert und hat die gleiche Aufgabe wie der Schalter in Fig. 3.

Bei dieser Schaltung wird ein geerdeter Widerstand R einer Tiefpassschaltung 2. Ordnung mit Hilfe des Transistors kurzgeschlossen. Die Verwendung einer Schaltung 2. Ordnung weist den Vorteil auf, dass die Einschwingzeit kürzer und die Welligkeit der Gleichspannung $U_{DC}$ bei einer geeigneten Dimensionierung gegenüber einer Schaltung 1. Ordnung kleiner ist.

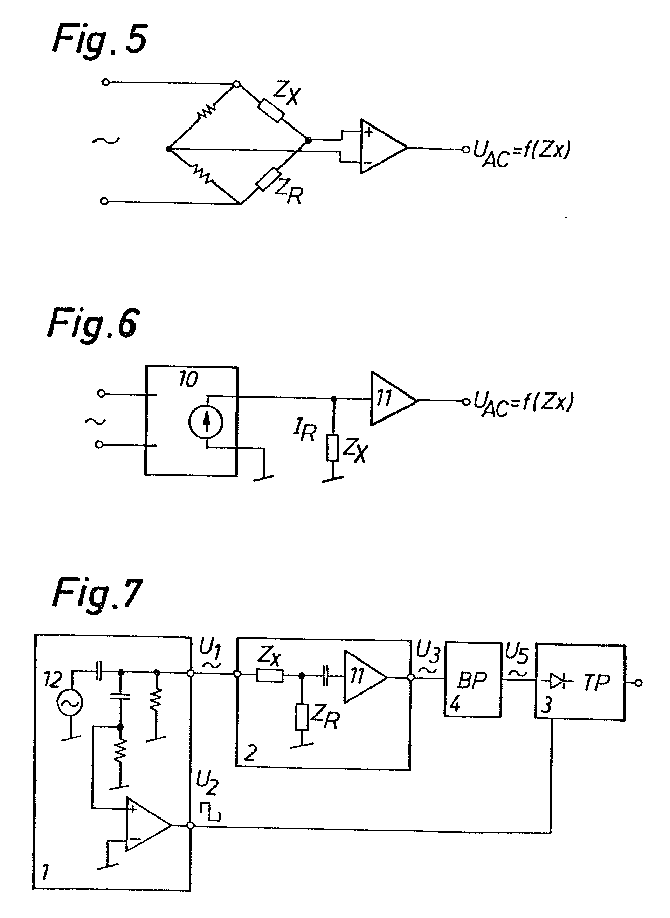

In Fig. 5 ist ein Ausführungsbeispiel der Messschaltung 2 (Fig. 2) schematisch dargestellt, welche in der erfindungsgemässen Schaltungsanordnung verwendet werden kann. Es handelt sich dabei um eine bekannte Brückenschaltung, deren verschiedene Abwandlungen in Frage kommen. Vorteilhaft wird der zu messenden Impedanz Zx eine Referenzimpedanz ZR zugeschaltet, die der gleichen Art wie die Impedanz Zx angehört. Handelt es sich z. B. bei Zx um eine Kapazität, so sollte die Referenzimpedanz ZR auch eine Kapazität sein, um eine Phasenverschiebung in der Messschaltung 2 zu vermeiden.

In Fig. 6 ist ein weiteres Ausführungsbeispiel der Messschaltung 2 (Fig. 2) schematisch dargestellt. Anstatt einer Brückenschaltung wird eine spannungsgesteuerte Stromquelle 10 verwendet, so dass ein Referenzstrom IR in die zu messende Impedanz Zx fliesst. Mit einem Impedanzwandler 11 wird die Spannung über der Impedanz Zx gemessen. Am Ausgang des Impedanzwandlers erscheint dann eine der Impedanz Zx direkt proportionale Wechselspannung U$_{AC}$, welche der Filterschaltung 4 in Fig. 2 zugeführt wird.

In Fig. 7 schliesslich ist ein Blockdiagramm der Schaltungsanordnung gemäss der Erfindung zur Messung einer elektrolytischen Impedanz Zx dargestellt. In der Oszillatorschaltung 1 wird ein Sinusoszillator 12 verwendet, seine Ausgangsspannung über einen Kondensator entkoppelt und mittels eines Komparators in Rechteckspannung U2 umgewandelt. Am Ausgang der Oszillatorschaltung 1 erhält man eine reine, sinusförmige Wechselspannung U1 ohne Gleichstromkomponente mit einer Rechteckspannung U2, welche zeitgleiche Nulldurchgänge mit der sinusförmigen Wechselspannung U1 aufweist. Bei diesem Ausführungsbeispiel ist besonders darauf zu achten, dass kein Gleichstrom durch die elektrolytischen Impedanzen Zx und ZR fliessen kann. In der Messschaltung 2 ist eine zu messende elektrolytische Impedanz Zx mit einer Referenzimpedanz ZR als ein Spannungsteiler zusammengeschaltet.

Der Ausgang dieses Spannungsteilers ist über einen Kondensator zur Gleichstromentkoppelung an einen Impedanzwandler 11 angeschlossen. Am Ausgang des Impedanzwandlers 11 und damit der Messschaltung 2 erscheint eine der zu messenden Impedanz Zx proportionale Wechselspannung U3, welche Oberwellen und Störfrequenzen aufweist.

Die Wechselspannung U3 wird an einen Bandpass 4 zweiter Ordnung abgegeben, dessen Mittenfrequenz gleich der Frequenz des Sinusoszillators 12 ist. Am Ausgang des Bandpasses erscheint eine Wechselspannung U5, welche zu der Rechteckspannung U2 um 0° oder ± 180° phasenverschoben ist und gleichzeitig mit dieser der in Fig. 4 dargestellten Gleichrichter- und Tiefpassschaltung 3 zugeführt wird. Die Schaltungsanordnung kann zur Messung der Feuchtigkeit und/oder des Wassergehaltes von feuchtempfindlichen, elektrolytischen Sensoren verwendet werden.

Es ist naheliegend, dass die erfindungsgemässe Schaltungsanordnung durch die Kombination der oben beschriebenen Ausführungen der einzelnen Elemente in verschiedenen Modifikationen ausführbar ist. Ebenfalls sind die Anwendung des erfindungsgemässen Verfahrens und die Verwendung der Schaltungsanordnung nicht nur auf elektrolytische Sensoren beschränkt. Die Impedanzen von induktiven, kapazitiven und sowohl einen Real- als auch Imaginärteil aufweisenden Sensoren können mit Hilfe der oben beschriebenen Erfindung gemessen werden.

Die erfindungsgemässe Anordnung stellt eine hohe Linearität bis zu sehr kleinen Spannungen des Messsignals (mV-Bereich) sicher.

## Patentansprüche

1. Verfahren zur Messung der Impedanz eines Sensors mittels einer sinusförmigen Wechselspannung mit einer vorbestimmten Frequenz, wobei die sinusförmige Wechselspannung gemeinsam mit einer zu der sinusförmigen Wechselspannung synchron laufenden, rechteckförmigen Wechselspannung erzeugt und an eine die zu messende Impedanz enthaltende Messschaltung (2) abgegeben wird, dadurch gekennzeichnet, dass die der Impedanz proportionale, aus der Messschaltung (2) abgegebene Wechselspannung in einer selektiven Schaltung (4) mit einem vorbestimmten Amplituden- und Phasengang in eine vorbestimmte Phasenbeziehung zu der rechteckförmigen Wechselspannung gebracht und dann mit Hilfe der rechteckförmigen Wechselspannung gleichgerichtet und in eine der Impedanz proportionale Gleichspannung umgewandelt wird, wobei die Gleichrichtung der der Impedanz proportionalen Wechselspannung und die Umwandlung in die der Impedanz proportionale Gleichspannung in einer Gleichrichter- und Tiefpassschaltung (3) mit Hilfe eines Schalters, der durch die rechteckförmige Wechselspannung gesteuert wird, durch Kurzschliessen eines geerdeten Widerstandes der Tiefpassschaltung durchgeführt wird.

2. Schaltungsanordnung zur Durchführung des Verfahrens nach Anspruch 1, mit einer Oszillatorschaltung (1) zur Erzeugung einer sinusförmigen Wechselspannung und einer zu der sinusförmigen Wechselspannung synchron laufenden, rechteckförmigen Wechselspannung, mit einer an die Oszillatorschaltung (1) angeschlossenen und die zu messende Impedanz enthaltenden Messschaltung (2), mit einer Gleichrichter- und Tiefpassschaltung (3) und mit einer zwischen der Messschaltung (2) und der Gleichrichter- und Tiefpassschaltung (3) angeschlossenen Filterschaltung (4), dadurch gekennzeichnet, dass die Gleichrichter- und Tiefpassschaltung (3) aus einer Tiefpassschaltung besteht, deren einer geerdeter Widerstand (R) mit einem durch die rechteckförmige Wechselspannung gesteuerten Schalter kurzschliessbar ist.

3. Schaltungsanordnung nach Anspruch 2, dadurch gekennzeichnet, dass die Messschaltung (2) eine Brückenschaltung und einen Impedanzwandler aufweist.

4. Schaltungsanordnung nach Anspruch 2 oder 3, dadurch gekennzeichnet, dass die Messschaltung (2) eine spannungsgesteuerte Stromquelle (10) und einen Impedanzwandler (11) aufweist.

5. Anwendung des Verfahrens nach Anspruch 1 zur Messung des Widerstandes einer elektrolytischen Lösung.

6. Anwendung nach Anspruch 5 zur Messung der Feuchtigkeit und/oder des Wassergehaltes.

## Claims

1. Method for measuring the impedance of a sensor by a sine-shaped AC voltage of defined frequency wherein the sine-shaped AC voltage is generated together and in synchronism with a square wave voltage and is applied to a measuring circuit (2) containing said impedance, characterized in that the AC voltage resulting from said measuring circuit (2) and proportional to said impedance is modified in a selective circuit (4) of a defined phase-frequency- and amplitude-frequency characteristic to be brought into a defined phase relation to said square wave voltage and then is rectified by means of said square wave voltage and transformed into a DC voltage proportional to said impedance, wherein said rectifying and transforming step is performed in a rectifier- and low-pass circuit (3) by means of a switch controlled by said square wave voltage for intermittently short-circuiting a grounded resistor of said low-pass circuit.

2. Arrangement for carrying out the method defined in claim 1 comprising an oscillator circuit (1) for generating a sine-shaped AC voltage and a square wave voltage in synchronism, a measuring circuit (2) connected to the oscillator circuit (1) and containing an impedance to be measured, a rectifier- and low-pass circuit (3) and a filter circuit (4) connected between said rectifier- and low-pass circuit (3) and said measuring circuit (2) characterized in that said rectifier- and low-pass circuit (3) being a low-pass circuit having a grounded resistor (12) and a switch controlled by said square wave voltage for short-circuiting said grounded resistor.

3. Arrangement as defined in claim 2, characterized in that said measuring circuit (2) comprises a bridge circuit and an impedance transformer.

4. Arrangement as defined in one of the claims 2 or 3, characterized in that said measuring circuit (2) comprises a voltage controlled current source (10) and an impedance transformer (11).

5. Application of the method of claim 1 in the measurement of an electrolytic solution resistance.

6. Application as defined in claim 5 in the measurement of humidity and water content.

**Revendications**

1. Procédé pour mesurer l'impédance d'une sonde au moyen d'une tension alternative sinusoïdale à fréquence prédéterminée, selon lequel la tension alternative sinusoïdale est produite conjointement à une tension alternative rectangulaire synchrone à la tension alternative sinusoïdale, et est fournie à un circuit de mesure (2) comportant l'impédance à mesurer, caractérisé en ce que la tension alternative, proportionnelle à l'impédance, fournie par le circuit de mesure (2), est amenée à un circuit sélectif (4) avec une amplitude et une phase prédéterminées, avec un décalage de phases prédéterminé par rapport à la tension alternative rectangulaire, et est ensuite redressée à l'aide de la tension alternative rectangulaire et transformée en une tension continue proportionnelle à l'impédance, le redressement de la tension alternative proportionnelle à l'impédance et la transformation en tension continue proportionnelle à l'impédance étant réalisées dans un circuit redresseur et passe-bas (3) à l'aide d'un interrupteur commandé par la tension alternative rectangulaire, par court-circuit d'une résistance mise à la masse du circuit passe-bas.

2. Dispositif pour la mise en œuvre du procédé de la revendication 1, comportant un circuit oscillateur (1) pour la production d'une tension alternative sinusoïdale et d'une tension alternative rectangulaire synchrone à la tension alternative sinusoïdale, un circuit de mesure (2) relié au circuit oscillateur (1) et comportant l'impédance à mesurer, un circuit redresseur et passe-bas (3), et un circuit de filtrage (4) connecté entre le circuit de mesure (2) et le circuit redresseur et passe-bas (3), caractérisé en ce que le circuit redresseur et passe-bas (3) est constitué d'un circuit passe-bas dont une résistance (R) mise à la masse peut être court-circuitée par un interrupteur commandé par la tension alternative rectangulaire.

3. Dispositif selon la revendication 2, caractérisé en ce que le circuit de mesure (2) comprend un montage en pont et un adaptateur d'impédance.

4. Dispositif selon la revendication 2 ou 3, caractérisé en ce que le circuit de mesure (2) comprend une source de courant (10) commandée par une tension, et un adaptateur d'impédance (11).

5. Utilisation du procédé de la revendication 1 pour la mesure de la résistance d'une solution électrolytique.

6. Utilisation selon la revendication 5 pour la mesure de l'humidité et/ou de la teneur en eau.

**Fig.1**

**Fig.2**

**Fig.3**

**Fig.4**

## Fig.5

$U_{AC} = f(Zx)$

## Fig.6

$U_{AC} = f(Zx)$

## Fig.7